# EUROPEAN PATENT APPLICATION

(11) **EP 3 211 662 A1**
(43) Date of publication of application: **30.08.2017**
(21) Application number: 16156919.9
(22) Date of filing: 23.02.2016
(51) Int. Cl.: H01L 21/67, H01L 21/68, H01L 21/683

(54) **AN APPARATUS AND ASSOCIATED METHODS**

(71) Applicant: Nokia Technologies Oy, 02610 Espoo (FI)
(72) Inventor: White, Richard, Huntingdon, PE28 9DY (GB); Bower, Chris, Ely, CB6 3EN (GB); Bottomley, Joseph, Fenstanton, Cambridgeshire PE28 9HU (GB); Yinglin, Liu, Cambridge, CB1 3SA (GB); Zoran, Radivojevic, Cambridge, CB3 0NP (GB)
(74) Representative: Potter Clarkson LLP

(57) **Abstract**

A thin film manipulator comprising: a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and a plurality of chambers positioned laterally across the chamber surface of the porous thin film manipulator interface, the plurality of chambers configured to allow: progressive removal of fluid laterally across the interface to provide a lateral pressure gradient which progressively decreases the pressure laterally across the thin film surface to progressively hold a thin film at the thin film surface and/or progressive application of fluid laterally across the interface to provide a lateral pressure gradient which progressively increases the pressure laterally across the thin film surface to progressively release an adhered thin film from the thin film surface.

## Description

### Technical Field

The present disclosure relates particularly to thin films, associated methods and apparatus. Certain examples specifically concern a thin film manipulator.

### Background

Research is currently being performed using thin films.

The listing or discussion of a prior-published document or any background in this specification should not necessarily be taken as an acknowledgement that the document or background is part of the state of the art or is common general knowledge.

### Summary

According to a first aspect, there is provided a thin film manipulator comprising:
a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and
a plurality of chambers positioned laterally across the chamber surface of the porous thin film manipulator interface, the plurality of chambers configured to allow one or more of:
   progressive removal of fluid laterally across the interface to provide a lateral pressure gradient which progressively decreases the pressure laterally across the thin film surface to progressively hold a thin film at the thin film surface; and
   progressive application of fluid laterally across the interface to provide a lateral pressure gradient which progressively increases the pressure laterally across the thin film surface to progressively release an adhered thin film from the thin film surface.

It will of course be appreciated that, in this context, the decrease of pressure would correspond to an increase in vacuum (e.g. sucking from the thin film face to the chamber face, or increasing negative pressure), and the increase of pressure would correspond to a decrease in vacuum (e.g. blowing, or less vacuum from the chamber face to the thin film face, or increasing positive pressure).

The thin film manipulator may be configured to provide the lateral pressure gradient by one or more of:
using a laterally varying chamber size; and
regulating the timing of the pressure change to the respective lateral chambers in a predefined lateral sequence.

The plurality of chambers may vary in size radially from substantially the centre of the chamber surface to the periphery of the chamber surface to provide the above-mentioned progressive pressure gradient.

The plurality of chambers may increase in size from a first lateral side of the chamber surface to an opposite lateral side of the chamber surface to provide the above-mentioned progressive pressure gradient.

The thin film manipulator may be configured to allow one or more of:
the progressive removal of fluid radially across the interface to provide a radial pressure gradient which progressively decreases the pressure radially across the thin film surface to progressively radially hold a thin film at the thin film surface; and
the progressive application of fluid radially across the interface to provide a radial pressure gradient which progressively increases the pressure radially across the thin film surface to progressively radially release an adhered thin film from the thin film surface.

The thin film manipulator may be configured to allow one or more of:
the progressive removal of fluid laterally across the interface from the first lateral side to the opposite lateral side of the thin film surface to provide a lateral pressure gradient which progressively decreases the pressure laterally across the thin film surface from the first lateral side to the opposite lateral side of the thin film surface to progressively hold a thin film at the thin film surface; and
the progressive application of fluid laterally across the interface from the first lateral side to the opposite lateral side of the thin film surface to provide a lateral pressure gradient which progressively increases the pressure laterally across the thin film surface from the first lateral side to the opposite lateral side of the thin film surface to progressively release an adhered thin film from the thin film surface.

The thin film manipulator may be configured to provide the lateral pressure gradient by using a laterally varying chamber size with connection to a common pressure regulator, the common pressure regulator configured to regulate the pressure in the plurality of chambers.

Regulating the timing of the pressure change may comprise regulating the timing of the pressure change to respective substantially equally sized chambers in a predefined lateral sequence. The thin film manipulator may comprise respective valves configured to allow each chamber to be individually addressable for pressure variation.

The porous thin film manipulator interface may have an accessible void fraction, determined as the volume of accessible voids within the porous thin film manipulator interface divided by the total volume of the porous thin film manipulator interface, between 0.2 and 0.9

The porous thin film manipulator interface may comprise pores within the size range of 0.5 µm to 1000 µm.

The plurality of chambers may be configured to progressively remove fluid laterally across the interface to provide a lateral pressure gradient in the range of 100mbar to 1.5bar. In certain examples the lateral pressure gradient may be between 100mbar and ambient pressure (approximately 1 bar). The lateral pressure gradient may be defined as the difference in pressure laterally across a length of porous thin film manipulator interface (e.g. from one side to an opposite side of the interface). Thus different chambers would have different pressures across the interface to provide the pressure gradient laterally across the interface.

The plurality of chambers may be configured to progressively apply fluid laterally across the interface to provide a lateral pressure gradient in the range of 100mbar to 1.5bar.

The porous thin film manipulator interface comprises one or more of: porous polymeric material, porous polytetrafluoroethylene, polyethylene-2,6-naphthalate, polyethylene terephthalate, polyimide, polycarbonate, polyethylene, polyurethane, polymethylmethacrylate, polystyrene, natural rubber, polyisoprene, polybutadiene, polychloraprene, polyisobutylene, nitrile butadiene, styrene butadiene, saturated elastomeric material, polydimethylsiloxane, silicone rubber, fluorosilicone rubber, fluoroelastomer, perfluoroelastomer, ethylene vinyl acetate, thermoplastic elastomer, styrene block copolymer, thermoplastic polyolefin, thermoplastic vulcanisate, thermoplastic polyurethane, thermoplastic copolyester, melt processable rubber, and Sati ® porous acoustic membrane.

The thin film manipulator may comprise a vacuum generator configured to develop the pressure difference between the chamber surface and the opposing thin film surface. The vacuum generator may comprise one or more of: a vacuum pump, a pipette, a syringe, and a deformable elastic member configured to take in fluid when the member is released from compression.

The thin film manipulator may comprise a fluid source configured to develop the pressure difference between the chamber surface and the opposing thin film surface. The fluid source may comprise one or more of: a gas source, a liquid source, an emulsion source, a pipette, a syringe, and an elastic fluid storage member configured to expel fluid when the member is compressed.

According to a further aspect, there is provided a method of using a thin film manipulator the thin film manipulator comprising:
a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and
a plurality of chambers positioned laterally across the chamber surface of the porous thin film manipulator interface;
the method comprising one or more of:
progressively removing fluid laterally across the interface to provide a lateral pressure gradient which progressively decreases the pressure laterally across the thin film surface to progressively hold a thin film at the thin film surface; and
progressively applying fluid laterally across the interface to provide a lateral pressure gradient which progressively increases the pressure laterally across the thin film surface to progressively release an adhered thin film from the thin film surface.

According to a further aspect, there is provided a method of making a thin film manipulator, the method comprising:
providing a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and
providing a plurality of chambers positioned laterally across the chamber surface of the porous thin film manipulator interface, the plurality of chambers configured to allow one or more of:
   progressive removal of fluid laterally across the interface to provide a lateral pressure gradient which progressively decreases the pressure laterally across the thin film surface to progressively hold a thin film at the thin film surface; and
   progressive application of fluid laterally across the interface to provide a lateral pressure gradient which progressively increases the pressure laterally across the thin film surface to progressively release an adhered thin film from the thin film surface.

The steps of any method disclosed herein do not have to be performed in the exact order disclosed, unless explicitly stated or understood by the skilled person.

Throughout the present specification, descriptors relating to relative orientation and position, such as "top", "bottom", "upper", "lower", "above" and "below", as well as any adjective and adverb derivatives thereof, are used in the sense of the orientation of the apparatus as presented in the drawings. However, such descriptors are not intended to be in any way limiting to an intended use of the described or claimed examples.

According to a further aspect, there is provided a computer program comprising computer code configured to perform any method or combination of methods disclosed herein.

Corresponding computer programs for implementing one or more steps of the methods disclosed herein are also within the present disclosure and are encompassed by one or more of the described examples.

One or more of the computer programs may, when run on a computer, cause the computer to configure a thin film manipulator, or configured any apparatus, including a circuit, controller, or device disclosed herein or perform any method disclosed herein. One or more of the computer programs may be software implementations, and the computer may be considered as any appropriate hardware, including a digital signal processor, a microcontroller, and an implementation in read only memory (ROM), erasable programmable read only memory (EPROM) or electronically erasable programmable read only memory (EEPROM), as non-limiting examples. The software may be an assembly program.

One or more of the computer programs may be provided on a computer readable medium, which may be a physical computer readable medium such as a disc or a memory device, or may be embodied as a transient signal. Such a transient signal may be a network download, including an internet download.

The present disclosure includes one or more corresponding aspects, example examples or features in isolation or in various combinations whether or not specifically stated (including claimed) in that combination or in isolation. Corresponding means for performing one or more of the discussed functions are also within the present disclosure.

The above summary is intended to be merely exemplary and non-limiting.

### Brief Description of the Figures

A description is now given, by way of example only, with reference to the accompanying drawings, in which:-
Figure 1 shows a schematic process flow for graphene transfer after growth;
Figure 2 shows a thin film manipulator according to examples described herein;
Figure 3a shows another thin film manipulator according to examples described herein;
Figure 3b shows a schematic valve timing scheme for timing pressure changes according to examples described herein;
Figures 4a-4c shows another thin film manipulator progressively holding and releasing a thin film according to examples described herein;
Figure 5 shows another thin film manipulator progressively holding a thin film according to examples described herein;
Figures 6a-6e illustrate a real world example of thin films handled using a thin film manipulator as described herein;
Figure 7a shows a method of using as thin film manipulator according to examples described herein;
Figure 7b shows a method of making a thin film manipulator according to examples described herein; and
Figure 8 shows a computer-readable medium comprising a computer program configured to perform, control or enable a method described herein.

### Description of Specific Aspects/Examples

Graphene and other two dimensional (2D) materials, which can all be considered as examples of thin films, have monolayer structures with interesting properties that are finding new applications due to unique properties such as high mobility and high charge carrier density. Graphene is a hexagonally ordered layer of carbon atoms and has a unique electronic band structure, with conic Dirac points at two inequivalent corners of the two-dimensional Brillouin zone. Several interesting features arise. These include the possibility of very high electron mobility, peculiar tunnelling and transport properties due to the linear dispersion relation near the Dirac points, and unusual excitation spectra in the quantum Hall regime with high magnetic fields. Graphene may exhibit magnetic order either due to intrinsic defects or impurities, or due to the spin alignment of edge states in finite systems. Graphene bi- and multilayers (thin films) offer intriguing possibilities for device concepts. Similarly other 2D and thin film materials with the same structure, but using other elements, are also being explored such as Silicene, Phosphorene, Germanene, Borophene and Stanene based upon Silicon, Phosphorous, Germanium, Boron and Tin respectively. Similar structures that comprise more than one element such as Hexagonal Boron nitride (hBN) Molybdenum disulphide (MoS₂) and Tungsten diselenide (WSe₂) are similarly finding new applications in electronics and sensing devices.

Many applications for 2D and thin film materials are emerging, including thin film transistors (TFTs) with high mobility, and extremely charge sensitive field effect transistors based upon graphene (graphene field effect transistors, GFETs). Such devices require high quality near single crystalline 2D material that is generally grown by chemical vapour deposition (CVD), and this can lead to challenges with both the growth and transfer processes. In particular the removal and transfer of the single molecular layer of atoms from the growth substrate to the target device can prove challenging. This presents a manufacturing challenge since although the creation of graphene flakes may be performed, the fabrication of single crystalline graphene and other 2D materials currently requires a high temperature deposition onto copper substrates, followed by aggressive etching steps. Similar challenges may be faced when working with 2D materials other than graphene, and other thin film materials.

A significant problem with the production of 2D and thin film material based devices is in reliable growth and transfer of high quality crystalline material to the target device. Although, for example, graphene can be grown at high temperature (∼1000°C) on a range of different substrates, good results are generally obtained with a copper substrate, due to the favourable catalytic reactions and partial solubility of carbon in copper. The copper growth substrate can be, for example, a thin (∼100nm) evaporated layer on a silicon wafer, or a copper foil several tens of micrometres thick. After high temperature growth, the graphene monolayer must be removed from the growth substrate without damage and transferred onto the target substrate or device.

Methods for graphene removal from a copper growth layer include wet chemical etching to remove the copper layer by dissolution, electrochemical release of the graphene leaving the copper layer intact, use of pressure or heat sensitive adhesive tapes and high pressure/voltage combinations. A sacrificial 'transfer layer' of solution coated polymer (often Poly(methyl methacrylate), PMMA) may aid with handling of the delicate graphene monolayer. The PMMA may be deposited onto the graphene before removal of the PMMA/graphene from the copper growth substrate. Despite this protective PMMA layer, handling 2D materials and thin films throughout these process steps presents significant challenges and pose a risk of damage to the material.

Depending upon the thickness of the growth substrate, the etching step requires a prescribed amount of time in an etch bath to remove the growth substrate. In some examples a concentrated etchant may be used initially to allow rapid removal of the growth substrate, then as the interface between the growth substrate and the graphene is reached, the sample may be removed from the concentrated etch solution into a more dilute etching solution to avoid damaging / doping the graphene. The graphene may then be removed, ideally without damage, and put into a rinsing tank to rinse away the liquid etchant, which may otherwise cause unwanted doping effects of the graphene. After rinsing the graphene it is removed from the rinse tank and transferred to the target substrate, and further rinsing steps are required to remove the sacrificial transfer layer, and clean the sample.

Current processing methods require several large, wet-processing baths, which the graphene must be moved between without damage. This limits the processing speed to allow sufficient dwell time in each tank and can result in damage to the graphene layer leading to decreased device performance. A general way for large scale and automated transfer of (e.g., graphene) thin films between baths and baths to substrate is still not available.

Examples disclosed herein provide methods and apparatus for handling graphene monolayers and other 2D and thin film materials (including materials of the order of one, two, three or up to ten mono-layers) throughout the pick-up, release and transfer processes. Certain examples may be considered to use vacuum-assisted segmented thin film manipulators to allow for dry transfer of the graphene/thin film to the target substrate. In general, examples disclosed herein relate to thin film manipulators comprising a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and a plurality of chambers positioned laterally across the chamber surface of the porous thin film manipulator interface. The plurality of chambers are configured to allow one or more of progressive removal of fluid laterally across the interface to provide a lateral pressure gradient which progressively decreases the pressure laterally across the thin film surface to progressively hold a thin film at the thin film surface, and progressive application of fluid laterally across the interface to provide a lateral pressure gradient which progressively increases the pressure laterally across the thin film surface to progressively release an adhered thin film from the thin film surface.

It will be appreciated that decreasing the pressure encompasses increasing the vacuum, due to increased sucking/fluid removal through the pores of the porous thin film manipulator interface from the thin film surface through the porous interface to the chamber surface. Pressure decrease at the thin film surface occurs by the removal of fluid across the interface because fluid is removed from the through-thickness pores of the porous thin film manipulator interface and is sucked from the thin film surface to the chamber surface.

Accordingly, it will be appreciated that increasing the pressure encompasses decreasing the vacuum (i.e. supplying fluid), due to increased positive fluid supply through the pores of the porous thin film manipulator interface from the chamber surface through the porous interface to the thin film surface. Pressure increase at the thin film surface occurs by the supply of fluid across the interface because fluid is provided to the through-thickness pores of the porous thin film manipulator interface and is pushed from the chamber surface through to the thin film surface. Pressure increase can also occur by the stopping of the application of aforementioned sucking.

Thin film manipulators described herein may be considered to use a segmented porous membrane as a porous thin film manipulator interface that contacts the thin film layer. The individual segments of the porous membrane can be controlled so as to either hold or release the thin film layer by application of vacuum or pressure to that segment. The thin film manipulator may be used to perform controlled gradual/progressive pickup and placement of the thin film, for example starting and finishing from the thin film sample edges, for example.

In some examples the attractive/suction force acting to pick up and hold the thin film on the manipulator may be gradually increased laterally across a length of the thin film to provide a controlled pick-up analogous to a gentle peeling force. The suction may act from the edges of the sample towards the centre in some examples, from the centre towards the edges in some examples, or from one edge of the sample to an opposite edge in some examples. Once the thin film is held on the thin film manipulator, the thin film manipulator may then be used to move the sample, for example, between etching and rinsing baths, before transferring the thin film to the target substrate.

Similarly to the thin film pick-up process, when transferring the thin film to a target substrate, the release force applied can be gradually increased laterally across the thin film to reduce the chance of bubbles or wrinkles becoming trapped between the thin film and the target substrate. The releasing action may act from the edges of the sample towards the centre in some examples, from the centre towards the edges in some examples, or from one edge of the sample to an opposite edge in some examples. This release process may be considered to be analogous to a roll lamination operation. The thin film manipulator may provide a high level of control over thin film sample positioning and force applied to the thin film.

Thin film manipulators described herein may be used for 2D and thin film material transfer and handling. In the microelectronics industry, there is an increased demand for using thinner and more flexible substrates and films. This increases the complexity and difficulty of manufacture because it requires the handling of thin films without deformation or damage to the thin film. Example thin film materials include polymers (such as ethylene propylene (FEP), polyester (PET), and polyimide (PI)), semiconductors (such as Si, GaAs and GaN) and thin metal foils (such as Ti, Al and Cu). These materials are widely used in optics, thin-film transistor display, and photovoltaic devices.

Certain examples described herein may be used in the handling of pre-formed thin films. Typically in thin film technologies, the thin film material is directly deposited or cast from a gaseous or liquid precursor directly on the final device. In the cases of graphene and other 2D materials and thin films for which the formation of the thin film is incompatible with the device substrate, then the thin film material may be formed separately from the device substrate and then transferred to the device substrate. Certain examples described herein may be used for such transfer.

If the mechanical stiffness of the thin film is insufficient to support its own weight, or the thin film is prone to fracture/tearing when handled by techniques such as tweezers or support by a few points on the underside of the thin film, a way of manipulating (picking up and releasing) the thin film with distributed support across the whole surface of the thin film is required. Certain examples described herein may provide such distributed support for transfer of a thin film.

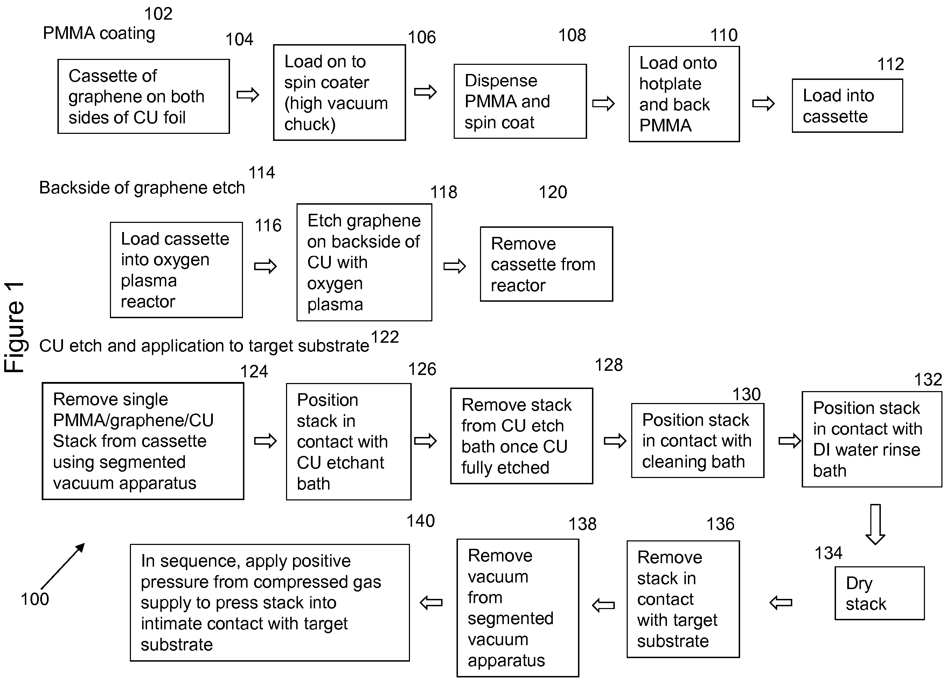

A typical example process flow for graphene transfer after growth, using a thin film manipulator as described herein, is shown in Figure 1. There are a large number of steps which involve sample handling, loading and transfer between processes (steps 106, 110, 112, 116, 120, 124, 126, 128, 130, 132, 136, 138, 140). These steps are highlighted with a solid border in Figure 1.

The PMMA coating stage 102 begins with a cassette of graphene in which graphene is present on both sides of a copper growth foil 104. The use of a cassette of graphene allows for batch processing. In other examples the graphene may be prepared as a single sheet/piece rather than in a batch. The graphene/copper is then loaded onto a spin coater 106. PMMA is dispensed and spin coated onto the graphene/copper 108. Figure 1 notes that a "high porosity vacuum chuck" is used in this example. If the graphene/copper layer is unable to support its own weight, a porous vacuum chuck may be used to support and hold the graphene/copper layer for the PMMA spin-coating process. Thereafter, a thin film manipulator may make contact with the PMMA side of the PMMA/graphene/Cu stack for further manipulation. The PMMA/graphene/copper is then loaded onto a hotplate to cure the PMMA 110. The resulting PMMA/graphene/copper is loaded onto a cassette 112.

In the backside graphene etch stage 114, the cassette is loaded into an oxygen plasma reactor 116, then the graphene is etched on the backside of the copper with oxygen plasma 118 to expose the copper for subsequent etching. The cassette is then removed from the reactor 120.

In the step of etching the copper and applying the graphene/PMMA to a target substrate 122, a single PMMA/graphene/copper stack is removed from the cassette using a thin film manipulator apparatus as described herein to pick up the stack 124 (the apparatus is called a segmented vacuum apparatus in Figure 1). The stack is positioned in contact with a copper etchant bath 126. The stack is then removed from the copper etch bath once the copper is fully etched away 128. The stack is then positioned in contact with a cleaning bath 130 to clean the stack. Then the stack is positioned in contact with a deionised (DI) water rinse bath 132 to rinse the stack. Following this, the stack is dried 134. The stack is then positioned in contact with a target substrate 136. The stack is then released from the thin film manipulator 138. This may be done in a roll lamination type action, in which positive pressure is applied in sequence across the thin film using a compressed gas supply to progressively press the stack into intimate contact with the target substrate 140.

The drying stage 134 allow for the dry transfer of graphene or other thin film to the final target substrate. Dry transfer is possible because the thin film manipulator does not require the thin film to remain wet during transfer, whereas other transfer techniques such as pick-up from a water/liquid bath provide a wet thin film. Dry transfer of graphene may be advantageous because thoroughly drying the graphene before application to a target substrate can help reduce liquid (e.g. water) contamination at the interface between the graphene and the target substrate. Liquid (water) contamination can be a source of unwanted doping and hysteresis in graphene based devices such as graphene field effect transistors (GFETs).Examples described herein allow for the PMMA/graphene stack (or the graphene if PMMA layers are not used) to be thoroughly dried prior to transfer to the device substrate. Close contact of the graphene with the substrate may be achieved by the application of pressure from the top-side to adhere the graphene to the device substrate.

Of course the method 100 shown in Figure 1 is one example of a graphene process flow and the skilled person will appreciate that thin film manipulators described herein may be used to handle different types of thin films and 2D materials. For example, 2D materials having a similar structure to graphene but comprising different elements, which are a single atom thick or few (e.g., up to 10) atoms thick, including Silicene, Phosphorene, Germanene, Borophene and Stanene (which are based upon Silicon, Phosphorous, Germanium, Boron and Tin respectively). As another example, other 2D and thin film structures that comprise more than one element include Hexagonal Boron nitride (hBN), Molybdenum disulphide (MoS₂) and Tungsten diselenide (WSe₂). Such materials may be also manipulated by certain examples described herein. Such materials may be used in technologies involving for 2D film manipulation, for example in the assembly and construction in different process flows of new electronics and sensing devices.

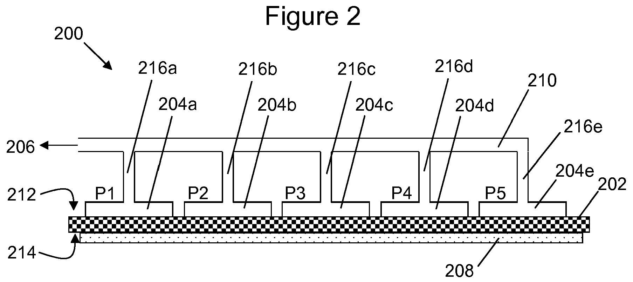

Figure 2 shows a thin film manipulator 200 according to examples described herein. A thin film 208 is fully adhered/held (by virtue of the aforementioned sucking) to the thin film surface 214 of the porous thin film manipulator interface 202 in this example.

The thin film manipulator 200 comprises a porous thin film manipulator interface 202 with a chamber surface 212 and an opposing thin film surface 214. The porous thin film manipulator interface 202 has a through-thickness porosity (i.e. through the interface 202 between the chamber surface 212 and the thin film surface 214) to allow a fluid to be used to develop a pressure difference between the chamber surface 212 and the opposing thin film surface 214.

The thin film manipulator 200 also comprises a plurality of chambers 204a-e positioned laterally across the chamber surface 212 of the porous thin film manipulator interface 202. The plurality of chambers 204a-e are configured to allow one or more of: progressive removal of fluid laterally across the interface 202 to provide a lateral pressure gradient which progressively decreases the pressure laterally across the thin film surface 214 to progressively hold a thin film 208 at the thin film surface 214; and progressive application of fluid laterally across the interface 202 to provide a lateral pressure gradient which progressively increases the pressure laterally across the thin film surface 214 to progressively release an adhered thin film from the thin film surface 214.

In this example a vacuum source 206 is acting to remove fluid through the interface 202 to hold a thin film 208 on the thin film surface 214. That is, the thin film manipulator 200 comprises a vacuum generator 206 in fluid connection with the plurality of chambers 204a-e, the vacuum generator 206 with the plurality of chambers 204a-e configured to remove fluid laterally across the chamber surface 212 to progressively decrease the pressure laterally across the thin film surface 214. The vacuum source/generator 206 may be, for example, a vacuum pump, a pipette, a syringe, or any deformable elastic cavity member/elastic membrane mechanism which is configured to take in/inhale fluid when the cavity member is released from compression (such a deformable elastic cavity member may also exhale/expel fluid when compressed/squeezed to act as a fluid source). Fluid may be taken into (and possibly expelled from) the cavity member itself or the cavity member may be connected to a further fluid vessel.

The thin film manipulator 200 in Figure 2 is shown holding a thin film 208 at the thin film surface 214. To progressively hold a thin film 208 at the thin film surface 214, the thin film manipulator 200 is configured to provide a pressure gradient laterally across the thin film surface 214 which is lower than the environmental pressure at the thin film surface 214 (e.g. the air pressure of the surrounding environment). The progressive removal of fluid laterally across the interface 202 (in other words, the progressive formation of a vacuum laterally across the interface 202) provides the lateral pressure gradient and acts to gradually laterally pick up the thin film 208 in a peeling action.

Fluid removal may be achieved, for example, using a vacuum pump or other suction device. Sucking fluid from the chambers 204a-e acts to lower the pressure at the chamber surface 212. Due to the through-thickness porosity of the porous thin film manipulator interface 202 which allows the passage of fluid through the thickness of the porous thin film manipulator interface 202, as the pressure is lowered at the chamber surface 212, the pressure is also lowered at the thin film surface 214 as fluid is sucked from the thin film surface 214 through the porous thin film interface 202 and out of the chamber surface 212 towards the vacuum source 206. In some examples using a thinner porous thin film manipulator interface (that is, a smaller separation between the chamber surface and the thin film surface) may allow for an improved response at the thin film surface to pressure changes at the chamber surface. Thus a sucking action is achieved at the thin film surface 214 to suck up a proximal thin film 208 and hold it at the thin film surface 214.

The plurality of chambers 204a-e may be configured to progressively remove fluid laterally across the interface to provide a lateral pressure gradient in the range of e.g. between 1mbar and 1500mbar. Higher pressures may be more suitable for picking up denser, heavier or stronger thin films. This pressure range may be high enough to allow for thin films to be picked up using a thin film manipulator 200 as described above while also being low enough that the thin films are not damaged by "rough handling", for example breaking up or tearing upon exposure to the sucking effect of the proximal lateral pressure gradient during or after pick-up. The lateral pressure gradient may vary across the thin film surface over a range between the order of 1 mbar to 1 bar depending on the material being manipulated. For example, to manipulate thin film type A the lateral pressure gradient may be between 2mbar and 5mbar (a 3mbar range within the pressure gradient range of 1mbar - 1 bar). For heavier thin film type B a lateral pressure gradient of 70mbar - 700mbar may be suitable (a 630mbar range within the pressure gradient range of 1 mbar to 1 bar). In any case a minimal pressure gradient which still allows the thin film to be picked up and deposited without damage to the film may be determined in tests.

The thin film manipulator 200 in Figure 2 may also be configured to release the thin film 208 from the thin film surface 214, for example to deposited the thin film 208 onto a target substrate. To progressively release a thin film 208 from the thin film surface 214, the thin film manipulator 200 may be configured to provide a pressure gradient laterally across the thin film surface 214 which is higher than the environmental pressure at the thin film surface 214 (e.g. the air pressure of the surrounding environment). The progressive application of fluid laterally across the interface 202 (in other words, the progressive formation of a positive pressure acting to push the thin film 208 away from the thin film surface 214) provides the lateral pressure gradient and acts to gradually laterally release the thin film 208 in a roll lamination action.

Fluid application may be achieved, for example, using a fluid source such as a gas source (e.g. a compressed air canister, or inert gas such as Nitrogen, Argon, Carbon Dioxide etc.), a liquid source (e.g., a water supply, or non-aqueous volatile liquid supply, the non-aqueous volatile liquid comprising, for example, isopropyl alcohol, an organic solvent or mixture of solvents), a pipette or a syringe (for the supply of gas and/or liquid), or any elastic fluid storage member configured to expel fluid when the member is compressed (such an elastic fluid cavity member may also act as a vacuum source if the cavity member is expanded/released from compression and fluid is taken into the cavity member. The cavity member may be connected to a further fluid vessel configured to take in/inhale fluid when the cavity member is released from compression.

Supplying fluid to the chambers 204a-e acts to increase the pressure at the chamber surface 212. Due to the through-thickness porosity of the porous thin film manipulator interface 202 which allows the passage of fluid through the thickness of the porous thin film manipulator interface 202, as the pressure is increased at the chamber surface 212, the pressure is also increased at the thin film surface 214 as fluid is supplied at the thin film surface 214 and moves through the lower-pressure porous thin film interface 202 and out of the chamber surface 212 towards the thin film 208. Thus a pushing action is achieved to release a proximal thin film 208 from the thin film surface 214. Of course, a similar effect could be achieved by stopping the application of sucking without supplying/pushing fluid through the pores.

The plurality of chambers 204a-e may be configured to progressively apply fluid laterally across the interface to provide a lateral pressure gradient in the range of 100mbar - 1500mbar. Lower pressures may be more suitable for releasing denser, heavier, less flexible or more robust thin films. The lateral pressure gradient may vary across the thin film surface over a range of approximately 100mbar - 1500mbar. This pressure range may be high enough to allow for thin films to be released within a practical timescale using a thin film manipulator 200 as described above while also being low enough that the thin films are not damaged by "rough handling", for example breaking up or tearing upon being pushed away from the thin film surface. The pressure range may also be suitable to allow for the release of the thin film gently and slowly enough to allow for accurate registration with and deposition onto a target substrate while reducing the chance of folds or bubbles being formed in the thin film.

In some examples there may not be a dedicated fluid source acting to positively push the thin film 208 away from the thin film surface 214. It may be that ceasing to apply a vacuum 206, and for example allowing the pressure in the chambers 204a-e to equilibrate to atmospheric (or other environmental) pressure by opening the chambers 204a-e to atmosphere/the surrounding environment is sufficient to provide the progressive application of fluid laterally across the interface 202 (due to the pressure gradually increasing in the chambers 204a-e which causes the pressure at the thin film surface 214 to gradually increase as fluid is able to flow through the porous interface 202 from the chambers 204a-e to the thin film surface 214) to progressively release the thin film 208.

The thin film manipulator 200 of Figure 2 comprises a plurality of fluid conduits 216a-e which are in fluid connection with the plurality of chambers. In this example each chamber 204a-e is in fluid connection with a dedicated conduit 216a-e. The plurality of fluid conduits 216a-e are configured to allow for one or more of the removal of, and application of, fluid laterally across the chamber surface from/to the chambers 204a-e. Also the thin film manipulator 200 of Figure 2 comprises a fluid manifold 210 in fluid connection with the plurality of fluid conduits 216a-e. The manifold 210 connects the vacuum source 206 to the chambers 204a-e via the dedicated conduits 216a-e.

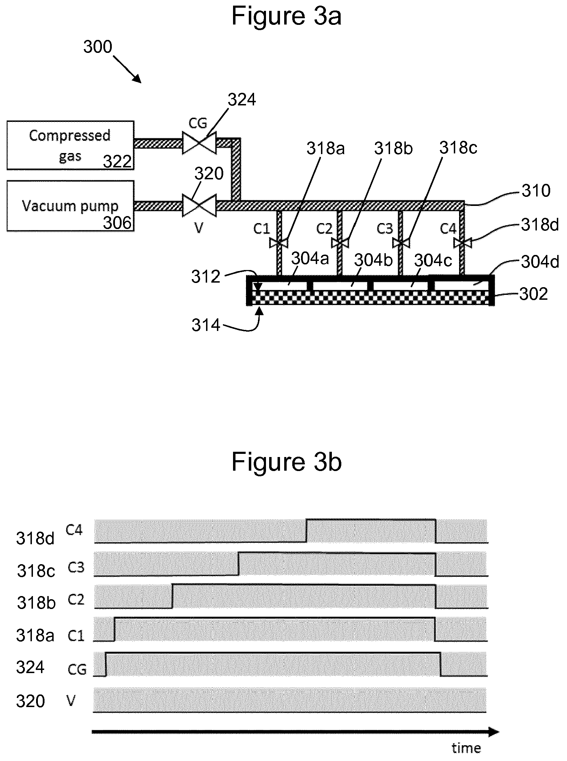

Figure 3a shows another thin film manipulator 300 according to examples described herein. The thin film manipulator 300 may be termed a segmented vacuum manipulator 300, in that it comprises a plurality of segments/chambers 304a-d and may be used to manipulate a thin film via the application of a vacuum. In this example all the chambers 304a-d are of substantially the same size/volume/footprint area on the chamber surface 312. The progressive removal of/application of fluid laterally across the interface 302 is achieved by a plurality of valves 318a-d configured to control the removal of/application of fluid to the interface 302.

Features shared with the thin film manipulator 300 of Figure 3a and the thin film manipulator 200 of Figure 2 include a porous thin film manipulator interface 302 with a chamber surface 312 and an opposing thin film surface 314. The porous thin film manipulator interface 302 has a through-thickness porosity to allow a fluid to be used to develop a pressure difference between the chamber surface 312 and the opposing thin film surface 314. The thin film manipulator 300 comprises a plurality of chambers 304a-d positioned laterally across the chamber surface 312 of the porous thin film manipulator interface 302.

In this example each chamber 304a-d is in fluid connection with both a vacuum source 306 (a vacuum pump 306) and a fluid source 322 (a compressed air vessel 322) via a dedicated chamber valve 318a-d (that is, each chamber 304a-d is connectable via a respective chamber valve 318a-d to a vacuum source 306 and a fluid source 322). Thus, the thin film manipulator 300 comprises a vacuum generator 306 in fluid connection with the plurality of chambers 304a-d, the vacuum generator 306 with the plurality of chambers 304a-d configured to remove fluid laterally across the chamber surface 312 to progressively decrease the pressure laterally across the thin film surface 314. The thin film manipulator 300 also comprises a fluid source 322 in fluid connection with the plurality of chambers 304a-d, the fluid source 322 with the plurality of chambers 304a-d configured to apply fluid laterally across the chamber surface 312 to progressively increase the pressure laterally across the thin film surface 314.

The vacuum source 302 is connectable to each of the valves 318a-d by a vacuum valve V 320. The fluid source 322 is also connectable to each of the valves 318a-d by a fluid source valve CG 324. Thus the thin film manipulator 300 comprises a plurality of individually addressable chambers 304a-d which may be used to apply either vacuum 306 or positive pressure 322 to different regions of the porous thin film manipulator interface 302 (which may also be termed a porous face-plate or a high-porosity chuck), using an array of individually addressable valves 318a-d.

The thin film manipulator 300 in this example is configured to progressively remove fluid laterally across the interface 302 to provide a lateral pressure gradient which progressively decreases the pressure laterally across the thin film surface 314 to progressively hold a thin film at the thin film surface 314 by regulating the timing of the pressure change to the respective lateral chambers 304a-d in a predefined lateral sequence (here, from left 304a to right 304d). Each substantially equally sized chamber 304a-d is individually addressable for pressure variation, and the respective valves 318a-d are configured to provide the lateral pressure gradient by regulating the timing of the pressure change, as shown in Figure 3b, to the respective lateral chambers 304a-d in the predefined lateral sequence.

Figure 3b shows a schematic valve timing scheme for timing pressure changes according to examples described herein. In this example a pressure supplied from the fluid source 322 by opening the fluid source value 322 (a pressure isolation valve CG 322Opening the fluid source value 324 is shown in Figure 3b as the "high" or open signal in the fluid source value trace 324 CG. The vacuum source is closed to the rest of the thin film manipulator 300 as shown by the "low" or closed signal in vacuum source trace 320 V.

The valves C1 318A to C4 318d are then opened in sequence starting from the left hand side of the manipulator 300 and finishing on the right hand side of the manipulator 300 with a time delay between the opening of each subsequent valve 318a-d across the chamber surface 312 from left to right. Thus in this example a thin film held on the thin film surface 314 of the porous thin film manipulator interface 302 will first be released from the region of the thin film surface 302 underneath the leftmost chamber 304a, followed by the thin film surface 302 region underlying the next chamber along to the right 304b, then the thin film surface 302 region underlying the next chamber along to the right 304c and finally the thin film surface 302 region underlying the rightmost chamber 304d opposite to the first left most chamber 304a would be released. Thus the film would be released in a roll lamination type action. In other words the apparatus 300 allows for the progressive application of fluid laterally across the interface 302 to provide a lateral pressure gradient (from left to right) which progressively increases the pressure laterally across the thin film surface from left to right, to progressively release an adhered thin film from the thin film surface 314.

A similar approach could be used to apply a spatially controlled vacuum to a thin film sample in order to pick it up in a peeling action. A vacuum may be generated using the vacuum source 306 by closing the fluid source value 324 (a pressure isolation valve CG 322) and opening the vacuum value V 324. To provide the progressive removal of fluid from the chambers 304a-d across the interface 302, the valves C1 318A to C4 318d may be opened in sequence. For example the valves 318a-d may be opened starting from the left hand side of the manipulator 300 and finishing on the right hand side of the manipulator 300 with a time delay between the opening of each subsequent valve 318a-d across the chamber surface 312 from left to right. Thus a thin film located underneath the porous thin film manipulator interface 302 will first be sucked/attracted towards the leftmost chamber 304a, followed by the next chamber along to the right 304b, then the next chamber along to the right 304c and finally towards the rightmost chamber 304d opposite to the first left most chamber 304a.

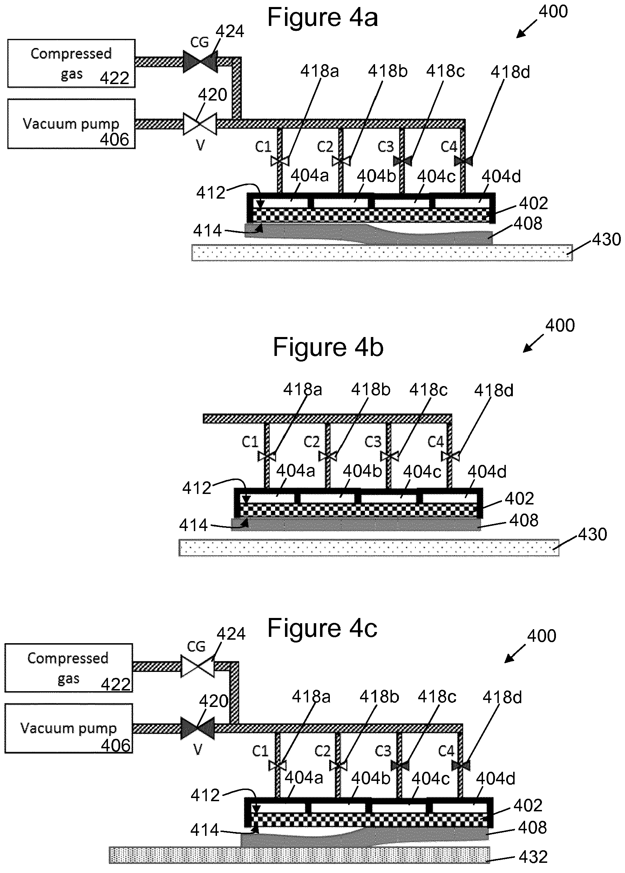

Figures 4a-4c shows the thin film manipulator of Figure 3a in use, progressively holding and releasing a thin film. Features shared with the thin film manipulators 200, 300 of Figure 2 and Figure 3a will not be described again in detail. In this example all the chambers 404a-d are of substantially the same size/volume/footprint area on the chamber surface 412.

In Figure 4a, the thin film manipulator 400 is progressively removing fluid laterally across the interface 402 to provide a lateral pressure gradient which progressively decreases the pressure laterally across the thin film surface 414 to progressively hold a thin film 408 at the thin film surface 414. Initially the vacuum is applied only at the edge of the thin film sample 408, then gradually vacuum is applied across the entire thin film sample 408 from left to right to create a gentle peeling action that lifts the sample 408 gradually off the substrate 430.

The vacuum valve 420 is open and the fluid source value 424 is closed. Firstly the left most value C1 418a was opened to pick up the left most side of the thin film 408. Figure 4a shows the stage of valves C1 418a and C2 418b being open such that the left half portion of the thin film 408 has been peeled up and is being held on the thin film surface 414 by vacuum acting at the thin film surface 414 due to the vacuum source 406 sucking fluid away from the chamber side 412 of the interface 402 which acts through the porous interface 402 to suck fluid away from the thin film surface 414. The next valves 418c and 418d would then be opened to the vacuum source 406 in sequence to allow for the thin film 408 to be picked up in a gentle peeling action and be entirely held by the thin film manipulator 400. This is shown in Figure 4b.

Once the sample 408 is completely held by the manipulator as in Figure 4b, it can for example be aligned with features on the target substrate 430 prior to transfer. This step may be automated, for example, using stepper motors and a vision system to locate and register to fiducial marks on the target substrate.

Release of the thin film 408 onto a substrate 430 is shown in Figure 4c. The pick-up of the thin film 408 is like the process shown in Figure 4a but in reverse. In Figure 4c, the thin film manipulator 400 is progressively applying fluid laterally across the interface 402 to provide a lateral pressure gradient which progressively increases the pressure laterally across the thin film surface 414 to progressively release the thin film 408 from the thin film surface 414. That is, positive pressure is applied to the thin film 408 starting at the edge of the sample 408, and gradually applied across the entire sample 408, so that the sample edge first comes into contact with the target substrate 430. This roll lamination action due to progressive release of the thin film 408 allows for gas to be pushed out as the rest of the sample 408 is carefully brought down onto the substrate 430. This gradual process also helps reduce wrinkles and air-bubbles being trapped underneath the deposited thin film 408.

In Figure 4c the vacuum valve 420 is closed and the fluid source value 424 is open. Firstly the left most valve C1 418a was opened to release the left most side of the thin film 408. Figure 4c shows the stage of valves C1 418a and C2 418b being open such that the left half portion of the thin film 408 has been released and is being deposited onto the underlying substrate 430 by pressure acting at the thin film surface 414 due to the fluid source 422 supplying fluid to the chamber side 412 of the interface 402 which acts through the porous interface 402 to supply fluid to the thin film surface 414. The next valves 418c and 418d would then be opened to the fluid source 422 in sequence to allow for the thin film 408 to be released in a roll lamination action and be carefully deposited by the thin film manipulator 400.

In the example of Figure 4a-4c, the pick-up and release occur across the thin film 408 from left to right (that is, from a first lateral side of the interface 402 to an opposite lateral side of the interface 402). Thus the thin film manipulator is configured to allow the progressive removal of fluid laterally across the interface 402 from the first lateral side (the side at which C1 418a is located) to the opposite lateral side (the side at which D4 418d is located) of the thin film surface 414 to provide a lateral pressure gradient which progressively decreases the pressure laterally across the thin film surface 414 from the first lateral side to the opposite lateral side of the thin film surface 414 to progressively hold a thin film 408 at the thin film surface 414, and the progressive application of fluid laterally across the interface 402 from the first lateral side to the opposite lateral side of the thin film surface 414 to provide a lateral pressure gradient which progressively increases the pressure laterally across the thin film surface 414 from the first lateral side to the opposite lateral side of the thin film surface 414 to progressively release an adhered thin film 408 from the thin film surface 414.

In another example, the pick-up may occur by first applying a vacuum to the centre of the thin film sample 408 so that the centre of the thin film sample 408 is picked-up and held at the thin film surface 414 initially, then the vacuum applied may be gradually increased radially outwards towards the edges of the sample 408 to gradually pick up the thin film 408 from its centre out towards its edges (similarly, the release may occur by first applying positive pressure to the centre of the thin film sample 408 so that the centre of the thin film sample 408 makes contact with the target substrate 430 initially, then the pressure applied may be gradually increased radially outwards towards the edges of the sample 408 to push out any air or wrinkles from underneath the thin film 408 as it is deposited from its centre outwards towards its edges). That is, the thin film manipulator 400 may be configured to allow one or more of the progressive removal of fluid radially across the interface 402 to provide a radial pressure gradient which progressively decreases the pressure radially across the thin film surface 414 to progressively radially hold a thin film at the thin film surface 414; and the progressive application of fluid radially across the interface 402 to provide a radial pressure gradient which progressively increases the pressure radially across the thin film surface 414 to progressively radially release an adhered thin film from the thin film surface 414.

Regulating the timing of the pressure change in these examples comprises regulating the timing of the pressure change applied to respective chambers 404a-d in a predefined lateral sequence using a plurality of values to adjust the pressure in each chamber 404a-d.

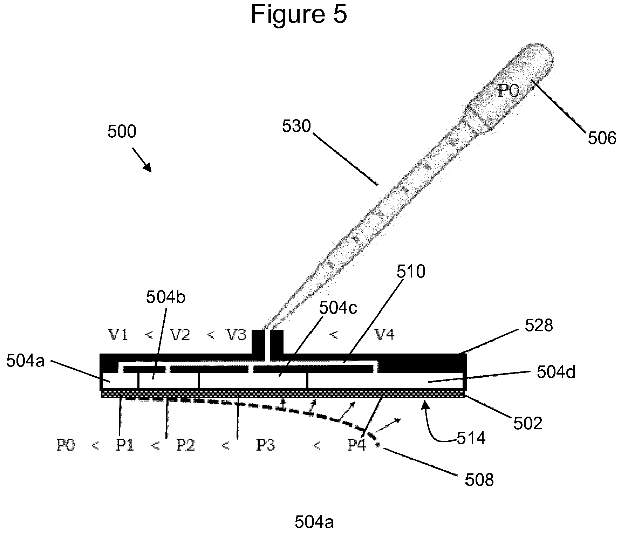

In the examples described in Figure 2, Figure 3a and Figures 4a-c the chambers 204a-d, 304a-d, 404a-d are of substantially the same size. In other examples the chambers 204a-d, 304a-d, 404a-d may be of different sizes. Differently sized chambers will be discussed in relation to Figure 5 below.

Figure 5 shows another thin film manipulator progressively picking up a thin film according to examples described herein. Features shared with the thin film manipulators 200, 300, 400 of Figure 2, Figure 3a and Figures 4a-c will not be described again in detail.

In this example all the chambers 504a-d are of different sizes/volumes/footprint areas on the chamber surface 512. That is, the plurality of chambers 504a-d progressively increase in size laterally across the chamber surface 512. Thus the thin film manipulator 500 is configured to provide the lateral pressure gradient by using a laterally varying chamber 504a-d size with connection to a common pressure regulator 506, the common pressure regulator 506 configured to regulate the pressure in the plurality of chambers 504a-d.

A top cover 528 is used to form the chambers 504a-d with the porous thin film manipulator interface 502. The progressive removal of/application of fluid laterally across the interface 502 is achieved by a combined vacuum/fluid source (in this example, a rubber bulb pipette) which is connected to each of the chambers 504a-d and is configured to vary the pressure in each of the plurality of chambers 504a-d at the same time. The variation of pressure laterally across the interface 502 is achieved because the chambers 504a-d are of a gradually varying volume across the interface 502.

A series of progressively varying volume chambers 504a-d are shown (volume V1 of chamber 504a is smaller than volume V2 of chamber 504b, which is smaller than volume V3 of chamber 504c, which in turn is smaller than volume V4 of chamber 504d.) Each chamber 504a-d is connected via the same fluid channel 510 to the pressure/vacuum generation means 506.

Releasing the rubber bulb of the pipette 506 (which has been squeezed to expel fluid within the pipette and bulb prior to positioning at the fluid channel 510) causes the rubber bulb to "inflate" and generate a vacuum pressure P0 (where P0 is less than the environmental pressure, e.g. atmospheric pressure). The rubber bulb 506 is made of elastomeric material which, when released, provides fluid flow from the chambers into the bulb volume). The pressure decrease P0 is distributed via the fluid channels 510 to the plurality of chambers 504a-d of different volumes. Since the porosity of the porous thin film manipulator interface 502 is substantially the same below each of the plurality of chambers 504a-d but the chambers 504a-d are of different volumes, different pressures form in each of the chambers 504a-d according to their volume as fluid is sucked from the chambers by the pipette. Larger chambers reach a weaker vacuum (are at a higher pressure) than smaller chambers.

This variation of pressure within each chamber 504a-d leads in turn to a variation in pressure at the thin film surface 514 as fluid is sucked through the porous thin film manipulator interface 502 into the chambers 504a-d and into the pipette 506. The pressure underneath the smaller chambers is lower i.e. the vacuum is higher than the pressure underneath the larger chambers. Thus a lateral pressure gradient is achieved across the thin film surface 514 which is lower at the left (as shown) under the smaller chambers, and which allows for a proximal thin film 508 to be gently peeled up from a substrate from the left to the right of the thin film manipulator, and held at the thin film surface 514 of the thin film manipulator 500. The net effect is that there is a greater vacuum underneath the smaller chamber, which leads to a larger force applied at the edge (504a) of the manipulator at the smallest chamber, and a progressively reducing attractive force towards the other edge (504d) at the largest chamber. This progressively laterally varying pressure helps to peel away layers from a substrate.

The above description of formation of a lateral progressively varying pressure may be the case initially immediately after the vacuum is applied (i.e. the bulb is released). Over time, since the chambers are all connected together, the pressure will gradually equalise in the chambers, and these pressure variations between chambers will reduce.

After picking up the thin film 508 it may be transported to a different location for release/deposition.

Squeezing the rubber bulb of the pipette 506 causes the rubber bulb to reduce in volume and pushes fluid from the bulb into the fluid channels 510 and then to the plurality of chambers 504a-d of different volumes. Since the porosity of the porous thin film manipulator interface 502 is substantially the same below each of the plurality of chambers 504a-d but the chambers 504a-d are of different volumes, different pressures form in each of the chambers 504a-d according to their volume as fluid is supplied to the chambers by the pipette. In the release mode, smaller chambers reach a higher pressure more quickly than larger chambers. This dynamic variation of pressure between each chambers 504a-d leads in turn to a variation in pressure at the thin film surface 514 as fluid is pushed through the porous thin film manipulator interface 502 from the chambers 504a-d. Therefore the pressure at the thin film surface 514 underneath the smaller chambers increases more quickly than the pressure underneath the larger chambers, because the chambers have different sizes. Thus a lateral pressure gradient is achieved across the thin film surface 514 which allows for a thin film 508 held at the thin film surface 514 to be gently pushed away from the manipulator 500 towards a substrate from left to right and be deposited onto a target substrate in a roll lamination action.

The thin film manipulator 500 of Figure 5 does not necessarily require bulky or expensive vacuum machinery such as a pump. It may also be portable, for example because it does not require connection to a bulky vacuum pump or a fluid source such as a compressed air container to provide pressure variations (the pipette can achieve this). Thus it may provide a low cost and low complexity apparatus/equipment for thin film manipulation. In other examples a syringe may be used instead of a pipette to remove fluid for thin film pick-up, and supply fluid for thin film release, in a similar way to the pipette. In other examples a vacuum pump and/or a fluid source may be connected to the chambers 504a-d to allow for thin film pick-up and release.

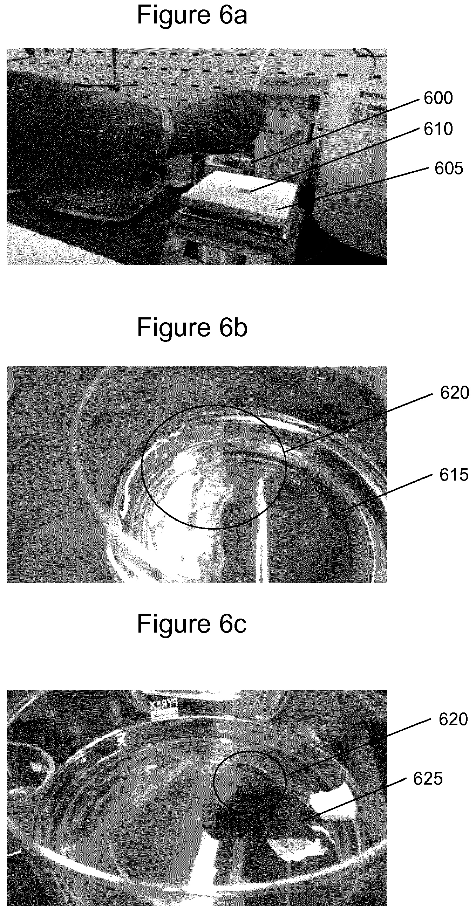

Figures 6a-6e illustrate a real world example of thin films handled using a thin film manipulator as described herein.

In this experiment, graphene (as an example of a thin film) was grown on a 25 µm thick copper foil by chemical vapour deposition CVD (using an Aixtron Black Magic CVD system). CVD of graphene on copper in this example comprises an initial annealing phase in a hydrogen/argon atmosphere and a growth phase, in which a methane precursor is introduced in the growth chamber.

After growth of the graphene, a polymer (poly(methyl methacrylate) (PMMA)) layer was spin-coated (at 1000 rpm for two minutes, followed by curing at 150°C for 30 minutes) on the graphene (the PMMA is present on the graphene on copper foil as a supporting layer to aid transfer).

Figure 6a shows the PMMA/graphene/copper stack 610 prior to being picked up from a hot plate 605 using a thin film manipulator 600 as described above. The thin film manipulator 600 is used to move the PMMA/graphene/copper stack 610 into an etching solution 615.

Figure 6b shows the PMMA/graphene stack 620 after the copper has been etched away in the etching solution 615, prior to being picked up using a thin film manipulator 600 as described above. The thin film manipulator 600 was used to move the PMMA/graphene stack 620 into a rinsing solution 625.

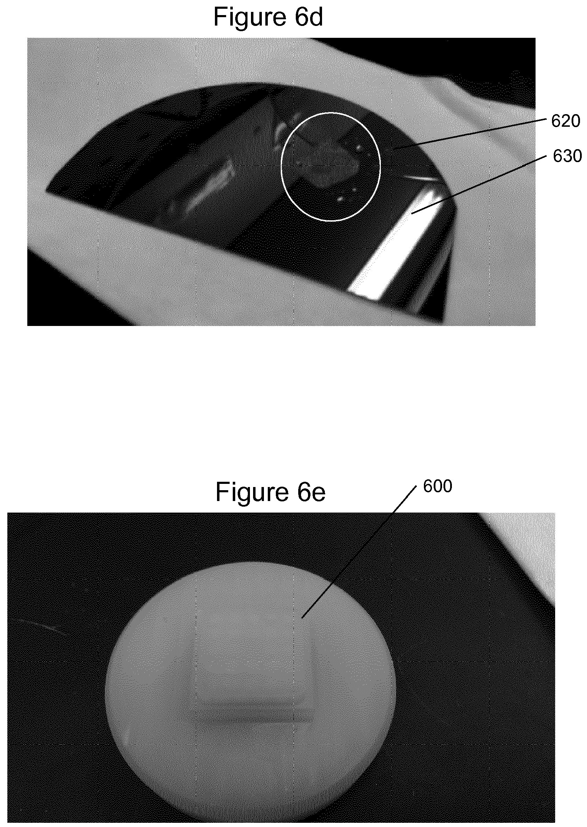

Figure 6c shows the PMMA/graphene stack 620 in the rinsing solution 625. The PMMA/graphene stack 620 was about 1 µm thick, and was rinsed in deionized water in the rinsing bath 625. After rinsing the PMMA/graphene stack 620 was picked up from the rinsing solution and transferred onto a target substrate 630 using the thin film manipulator 600 as described above (shown in Figure 6d).

Figure 6e shows a segment of the thin film manipulator 600 used to perform the manipulations shown in Figures 6a-6c. The upper face shown is the thin film surface of the manipulator which is configured to contact a thin film. Underneath the porous thin film manipulator interface shown are a series of chambers as described above. The segment of the thin film manipulator 600 shown may be attached at its underside (as shown in the Figure) to a vacuum generator and/or a fluid source by, for example, a flexible hose.

Porous thin film manipulator interfaces 202, 302, 402, 502 described herein may have an accessible void fraction, determined as the volume of accessible voids within the porous thin film manipulator interface divided by the total volume of the porous thin film manipulator interface, between 0.2 and 0.9. Accessible void fraction is a relevant measure of porosity because it must be possible for fluid to pass through the porous thin film manipulator interface, i.e. from the chamber side to the thin film side and vice versa. Thus the voids must be accessible (as opposed to a material having closed cells which are not accessible from an outer surface of the material). The range of 0.2-0.9 may include materials up to extremely porous aerogel type materials which may have a void fraction of approximately 0.9. In certain examples there may be negligible porosity variation laterally across a length of the porous thin film manipulator interface.

Porous thin film manipulator interfaces 202, 302, 402, 502 described herein may comprise pores within the size range of 0.5 µm to 1000 µm. In general smaller pores may be more appropriate for fragile thin film materials since the fluid flow rate through the pores is reduced, along with the likelihood of damaging the material. The modulus of the porous material used for the porous thin film manipulator interface may also be important, with softer materials such as polymers, elastomers and rubbers reducing the likelihood of damage to a more fragile thin film during manipulation.

Thin film manipulator interfaces 200, 300, 400, 500 described herein may comprise a plurality of chambers configured to progressively remove fluid laterally across the interface to provide a lateral pressure gradient in the range of 100mbar to 1.5bar. The plurality of chambers may be configured to progressively apply fluid laterally across the interface to provide a lateral pressure gradient in the range of 100mbar to 1.5bar. Lateral pressure gradients covering pressures of approximately 750mbar may be used to pick up semiconductor wafers. Such lateral pressure gradients may also be suitable for thinner materials. The manipulation of more fragile thin films may require a narrower lateral pressure gradient and/or a pressure range closer to ambient pressure to be used to reduce the risk of damaging the thin film.

Porous thin film manipulator interfaces 202, 302, 402, 502 described herein may comprise one or more of: porous polymeric material, for example porous polytetrafluoroethylene (PTFE), porous polytetrafluoroethylene, polyethylene-2,6-naphthalate (PEN), polyethylene terephthalate (PET), polyimide (PI), polycarbonate (PC), polyethylene (PE), polyurethane (PU), polymethylmethacrylate (PMMA), polystyrene (PS); natural rubber, for example polyisoprene, polybutadiene, polychloraprene, polyisobutylene, nitrile butadiene, styrene butadiene; saturated elastomeric materials, for example polydimethylsiloxane (PDMS); silicone rubbers, for example, fluorosilicone rubber, fluoroelastomer, perfluoroelastomer, ethylene vinyl acetate (EVA); thermoplastic elastomers, for example styrene block copolymer, thermoplastic polyolefin, thermoplastic vulcanisate, thermoplastic polyurethane (TPU), thermoplastic copolyesters; melt processable rubber, and Sati ® porous acoustic membrane.

One or more examples described herein may allow for simplified processing and sample handling of 2D and other thin film samples. Dry transfer of thin films may be advantageous by reducing water contamination in devices fabricated using the thin film, since water contamination can detrimentally affect device performance. One or more examples described herein may allow for improved manipulation of thin films by reducing the risk of residues remaining on the thin film which may be present using other thin film handling techniques which rely on using a polymer layer on the thin film to aid thin film handling. Residues such as polymer residue may adversely affect device performance of a device comprising the thin film, for example by doping the thin film and otherwise negatively affecting the thin film electronic properties. The worked example described herein uses a polymer layer to aid thin film handling but it is possible to manipulate thin films using apparatus and methods as described herein without a handling film/polymer layer being applied to the thin film.

One or more examples described herein may allow for improved thin film deposition by reducing the chances of bubbles and/or wrinkles in the deposited thin film by providing a roll lamination deposition action due to the progressive release of the thin film. One or more examples may allow for improved alignment of the thin film on a target substrate and for greater control over thin film handling and transfer by allowing for simple safe handling of the thin film. Thin films handled according to one or more examples described here may be less likely to be damaged during manipulation by, for example, folding, tearing or stretching due to the gentle pick-up and release action provided by the progressive holding and release of the thin film. While examples herein relate to the handling of graphene, of course other thin films may be handled as described herein.

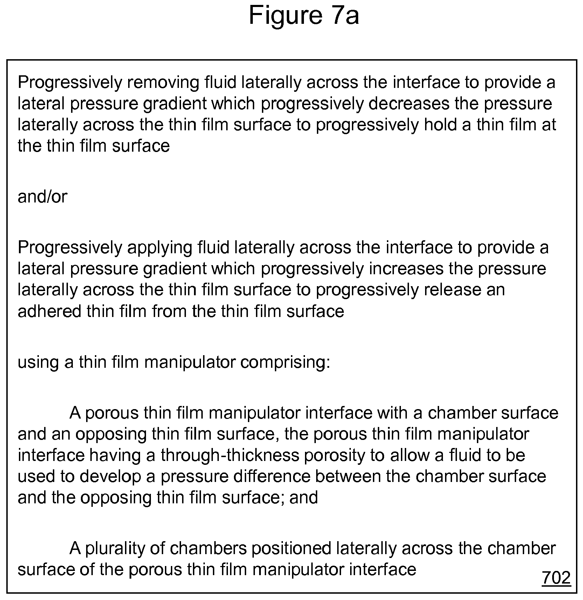

Figure 7a shows a method of using as thin film manipulator according to examples described herein. The method is a method of using a thin film manipulator comprising a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and a plurality of chambers positioned laterally across the chamber surface of the porous thin film manipulator interface. The method 702 comprises one or more of: progressively removing fluid laterally across the interface to provide a lateral pressure gradient which progressively decreases the pressure laterally across the thin film surface to progressively hold a thin film at the thin film surface; and progressively applying fluid laterally across the interface to provide a lateral pressure gradient which progressively increases the pressure laterally across the thin film surface to progressively release an adhered thin film from the thin film surface.

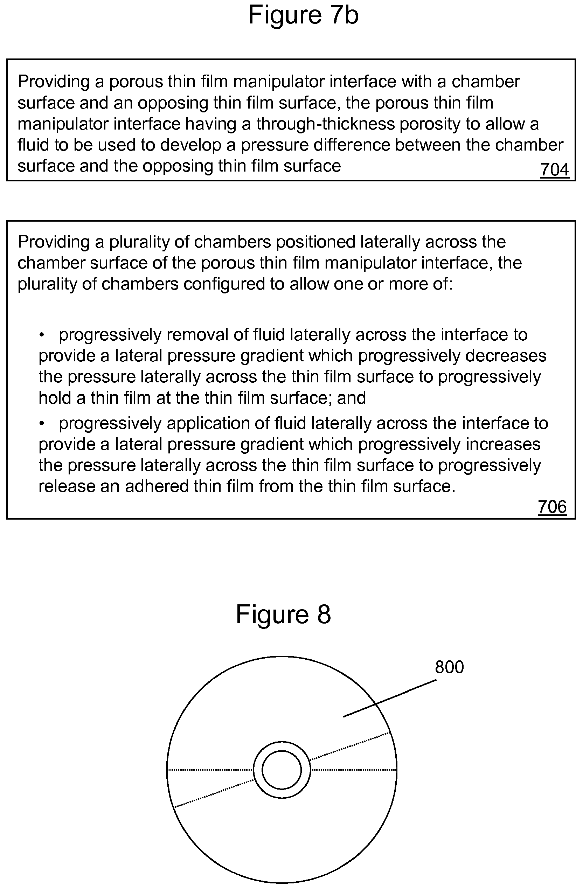

Figure 7b shows a method of making a thin film manipulator according to examples described herein. The method of making a thin film manipulator comprises providing a porous thin film manipulator interface with a chamber surface and an opposing thin film surface, the porous thin film manipulator interface having a through-thickness porosity to allow a fluid to be used to develop a pressure difference between the chamber surface and the opposing thin film surface 704; and providing a plurality of chambers positioned laterally across the chamber surface of the porous thin film manipulator interface 706. The plurality of chambers are configured to allow one or more of: progressive removal of fluid laterally across the interface to provide a lateral pressure gradient which progressively decreases the pressure laterally across the thin film surface to progressively hold a thin film at the thin film surface; and progressive application of fluid laterally across the interface to provide a lateral pressure gradient which progressively increases the pressure laterally across the thin film surface to progressively release an adhered thin film from the thin film surface.

Figure 8 shows a computer-readable medium 800 comprising a computer program configured to perform, control or enable a method described herein, for example a method of making a thin film manipulator or a method of using a thin film manipulator as described herein. The computer program 800 may comprise computer code configured to perform, control or enable one or more of the method steps 702 of Figure 7a and/or one or more method steps 704, 706 of Figure 7b. In this example, the computer/processor readable medium 800 is a disc such as a digital versatile disc (DVD) or a compact disc (CD). In other examples, the computer/processor readable medium 800 may be any medium that has been programmed in such a way as to carry out an inventive function. The computer/processor readable medium 800 may be a removable memory device such as a memory stick or memory card (SD, mini SD, micro SD or nano SD).

Other examples depicted in the figures have been provided with reference numerals that correspond to similar features of earlier described examples. For example, feature number 1 can also correspond to numbers 101, 201, 301 etc. These numbered features may appear in the figures but may not have been directly referred to within the description of these particular examples. These have still been provided in the figures to aid understanding of the further examples, particularly in relation to the features of similar earlier described examples.

It will be appreciated that any "computer" described herein can comprise a collection of one or more individual processors/processing elements that may or may not be located on the same circuit board, or the same region/position of a circuit board or even the same device. In some examples one or more of any mentioned processors may be distributed over a plurality of devices. The same or different processor/processing elements may perform one or more functions described herein.

With reference to any discussion of any mentioned computer and/or processor and memory (e.g. including ROM, CD-ROM etc), these may comprise a computer processor, Application Specific Integrated Circuit (ASIC), field-programmable gate array (FPGA), and/or other hardware components that have been programmed in such a way to carry out the inventive function.

The applicant hereby discloses in isolation each individual feature described herein and any combination of two or more such features, to the extent that such features or combinations are capable of being carried out based on the present specification as a whole, in the light of the common general knowledge of a person skilled in the art, irrespective of whether such features or combinations of features solve any problems disclosed herein, and without limitation to the scope of the claims. The applicant indicates that the disclosed aspects/examples may consist of any such individual feature or combination of features. In view of the foregoing description it will be evident to a person skilled in the art that various modifications may be made within the scope of the disclosure.

While there have been shown and described and pointed out fundamental novel features as applied to different examples thereof, it will be understood that various omissions and substitutions and changes in the form and details of the devices and methods described may be made by those skilled in the art without departing from the spirit of the invention. For example, it is expressly intended that all combinations of those elements and/or method steps which perform substantially the same function in substantially the same way to achieve the same results are within the scope of the invention. Moreover, it should be recognized that structures and/or elements and/or method steps shown and/or described in connection with any disclosed form or example may be incorporated in any other disclosed or described or suggested form or example as a general matter of design choice. Furthermore, in the claims means-plus-function clauses are intended to cover the structures described herein as performing the recited function and not only structural equivalents, but also equivalent structures. Thus although a nail and a screw may not be structural equivalents in that a nail employs a cylindrical surface to secure wooden parts together, whereas a screw employs a helical surface, in the environment of fastening wooden parts, a nail and a screw may be equivalent structures.

## Claims

1. A thin film manipulator comprising:
a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and
a plurality of chambers positioned laterally across the chamber surface of the porous thin film manipulator interface, the plurality of chambers configured to allow one or more of:
progressive removal of fluid laterally across the interface to provide a lateral pressure gradient which progressively decreases the pressure laterally across the thin film surface to progressively hold a thin film at the thin film surface; and
progressive application of fluid laterally across the interface to provide a lateral pressure gradient which progressively increases the pressure laterally across the thin film surface to progressively release an adhered thin film from the thin film surface.

2. The thin film manipulator of claim 1, wherein the thin film manipulator is configured to provide the lateral pressure gradient by one or more of:
using a laterally varying chamber size; and
regulating the timing of the pressure change to the respective lateral chambers in a predefined lateral sequence.

3. The thin film manipulator of claim 1, wherein the thin film manipulator is configured to allow one or more of:
the progressive removal of fluid radially across the interface to provide a radial pressure gradient which progressively decreases the pressure radially across the thin film surface to progressively radially hold a thin film at the thin film surface; and
the progressive application of fluid radially across the interface to provide a radial pressure gradient which progressively increases the pressure radially across the thin film surface to progressively radially release an adhered thin film from the thin film surface.

4. The thin film manipulator of claim 1, wherein the thin film manipulator is configured to allow one or more of:
the progressive removal of fluid laterally across the interface from the first lateral side to the opposite lateral side of the thin film surface to provide a lateral pressure gradient which progressively decreases the pressure laterally across the thin film surface from the first lateral side to the opposite lateral side of the thin film surface to progressively hold a thin film at the thin film surface; and
the progressive application of fluid laterally across the interface from the first lateral side to the opposite lateral side of the thin film surface to provide a lateral pressure gradient which progressively increases the pressure laterally across the thin film surface from the first lateral side to the opposite lateral side of the thin film surface to progressively release an adhered thin film from the thin film surface.

5. The thin film manipulator of claim 2, wherein the thin film manipulator is configured to provide the lateral pressure gradient by using a laterally varying chamber size with connection to a common pressure regulator, the common pressure regulator configured to regulate the pressure in the plurality of chambers.

6. The thin film manipulator of claim 2, wherein regulating the timing of the pressure change comprises regulating the timing of the pressure change to respective substantially equally sized chambers in a predefined lateral sequence.

7. The thin film manipulator of claim 1, wherein the porous thin film manipulator interface has an accessible void fraction, determined as the volume of accessible voids within the porous thin film manipulator interface divided by the total volume of the porous thin film manipulator interface, between 0.2 and 0.9.

8. The thin film manipulator of claim 1, wherein the porous thin film manipulator interface comprises pores within the size range of 0.5 µm to 1000 µm.

9. The thin film manipulator of claim 1, wherein one or more of:
the plurality of chambers is configured to progressively remove fluid laterally across the interface to provide a lateral pressure gradient in the range of 100mbar to 1.5bar; and
the plurality of chambers is configured to progressively apply fluid laterally across the interface to provide a lateral pressure gradient in the range of 100mbar to 1.5bar.

10. The thin film manipulator of claim 1, wherein the porous thin film manipulator interface comprises one or more of: porous polymeric material, porous polytetrafluoroethylene, polyethylene-2,6-naphthalate, polyethylene terephthalate, polyimide, polycarbonate, polyethylene, polyurethane, polymethylmethacrylate, polystyrene, natural rubber, polyisoprene, polybutadiene, polychloraprene, polyisobutylene, nitrile butadiene, styrene butadiene, saturated elastomeric material, polydimethylsiloxane, silicone rubber, fluorosilicone rubber, fluoroelastomer, perfluoroelastomer, ethylene vinyl acetate, thermoplastic elastomer, styrene block copolymer, thermoplastic polyolefin, thermoplastic vulcanisate, thermoplastic polyurethane, thermoplastic copolyester, melt processable rubber, and Sati ® porous acoustic membrane.

11. The thin film manipulator of claim 1 comprising a vacuum generator configured to develop the pressure difference between the chamber surface and the opposing thin film surface, wherein the vacuum generator comprises one or more of: a vacuum pump, a pipette, a syringe, and a deformable elastic member configured to take in fluid when the member is released from compression.

12. The thin film manipulator of claim 1 comprising a fluid source configured to develop the pressure difference between the chamber surface and the opposing thin film surface, wherein the fluid source comprising one or more of: a gas source, a liquid source, an emulsion source, a pipette, a syringe, and an elastic fluid storage member configured to expel fluid when the member is compressed.

13. A method of using a thin film manipulator, the thin film manipulator comprising:
a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and
a plurality of chambers positioned laterally across the chamber surface of the porous thin film manipulator interface;
the method comprising one or more of:
progressively removing fluid laterally across the interface to provide a lateral pressure gradient which progressively decreases the pressure laterally across the thin film surface to progressively hold a thin film at the thin film surface; and
progressively applying fluid laterally across the interface to provide a lateral pressure gradient which progressively increases the pressure laterally across the thin film surface to progressively release an adhered thin film from the thin film surface.

14. A method of making a thin film manipulator, the method comprising:
providing a porous thin film manipulator interface with a chamber surface and an opposing thin film surface, the porous thin film manipulator interface having a through-thickness porosity to allow a fluid to be used to develop a pressure difference between the chamber surface and the opposing thin film surface; and
providing a plurality of chambers positioned laterally across the chamber surface of the porous thin film manipulator interface, the plurality of chambers configured to allow one or more of:
progressive removal of fluid laterally across the interface to provide a lateral pressure gradient which progressively decreases the pressure laterally across the thin film surface to progressively hold a thin film at the thin film surface; and
progressive application of fluid laterally across the interface to provide a lateral pressure gradient which progressively increases the pressure laterally across the thin film surface to progressively release an adhered thin film from the thin film surface.

15. A computer program comprising computer code configured to perform the method of any of claims 13-14.
